# EUROPÄISCHE PATENTSCHRIFT

(11) **EP 1 827 934 B1**
(45) Veröffentlichungstag und Bekanntmachung des Hinweises auf die Patenterteilung: **16.10.2013**
(21) Anmeldenummer: 05816263.7
(22) Anmeldetag: 13.12.2005
(51) Int. Cl.: B60T 8/36, H05K 7/00, B60T 17/00

(54) **ELEKTROHYDRAULISCHE DRUCKREGELVORRICHTUNG FÜR KRAFTFAHRZEUGBREMSSYSTEME**
ELECTROHYDRAULIC PRESSURE CONTROL DEVICE FOR AUTOMOTIVE BRAKE SYSTEMS
DISPOSITIF DE REGULATION DE PRESSION ELECTROHYDRAULIQUE POUR SYSTEMES DE FREINAGE DE VEHICULES A MOTEUR

(30) Priorität: 21.12.2004 DE 102004062719; 13.12.2005 DE 102005059941
(43) Veröffentlichungstag der Anmeldung: 05.09.2007
(73) Patentinhaber: Continental Teves AG & Co. oHG, 60488 Frankfurt am Main (DE)
(72) Erfinder: HEISE, Andreas, 64390 Erzhause (DE); ERLER, Wolfgang, 65232 Taunusstein (DE)
(74) Vertreter: Brand, Markus
(86) Internationale Anmeldenummer: PCT/EP2005/056738
(87) Internationale Veröffentlichungsnummer: WO 2006/067070

(56) Entgegenhaltungen:
- EP-A- 1 041 700
- DE-A1- 10 011 807
- DE-A1- 10 036 086
- DE-A1- 10 122 330
- US-B1- 6 786 466

## Beschreibung

Die Erfindung betrifft eine elektrohydraulische Druckregelvorrichtung für Kraftfahrzeugbremssysteme gemäß Oberbegriff von Anspruch 1.

Aus der EP 0 520 047 B1 (P 7129) ist ein ABS-Steuergerät bekannt, welches nach dem Prinzip eines sogenannten "magnetischen Steckers" mit beweglichen, elastisch gehaltenen Ventilspulen in einem Elektronikgehäuse aufgebaut ist. Die Elektronikeinheit (ECU) mit integrierter Leiterplatte und den Ventilspulen ist dabei steckbar mit einem Ventilblock (HCU) verbunden, welcher die Ventildome und weitere Hydraulikkomponenten des Bremsenaggregats umfasst. Die ECU umfasst weiterhin einen meist seitlich angeordneten integrierten Stecker zum Anschluss eines Verbindungskabels (z.B. Radsensorkabel). Steuergeräte nach diesem Prinzip haben sich im Automobilbau durchgesetzt und werden daher weit verbreitetet für vielfältige Regelungsaufgaben (z.B. ABS, ESP etc.) in Kraftfahrzeugbremssystemen eingesetzt.

Aus der DE 100 11 807 A1 (P 9817) ist ein Steuergerät für eine "brake-by wire"- Bremsanlage mit Zielrichtung elektrohydraulische Bremse (EHB) bekannt. Diese Schrift offenbart ein Reglergehäuse mit einem Deckel aus Aluminium mit Rippen oder Noppen zur verbesserten Kühlung der darin enthaltenen elektronischen Bauelemente. Der Gehäuserahmen ist mittels einer umlaufenden Dichtung auf der Verbindungsfläche, aus der die Ventildome herausragen, an das Reglergehäuse angebunden. Wegen des hohen Anteils an schwierig zu fertigenden Metallteilen ist diese Konstruktion für die Massenfertigung noch nicht ausreichend optimiert.

In der gattungsgemäßen DE 100 36 086 A1 ist eine Bremsdruckregelvorrichtung beschrieben, welche einen Elektromotor zum Antreiben einer in einem Ventilblock vorgesehenen Pumpe umfasst, wobei der Elektromotor über einen Anschlussadapter, der durch eine Bohrung in dem Ventilblock geführt ist, mit einem Schaltungsträger elektrisch leitend verbunden ist. An dem Anschlussadapter sind auf Seiten des Schaltungsträgers elastische oder nachgiebige Kontaktelemente zur Kontaktierung vorgesehen, welche in axialer Richtung einen Druck bzw. eine Kraft auf den Schaltungsträger ausüben.

Aufgabe der vorliegenden Erfindung ist es nun, ein elektrohydraulisches ABS/ESP-Steuergerät der eingangs genannten Art, welches eine hohe Kühlkapazität hat, mit noch weiter verringertem baulichen als auch funktionellen Mitteleinsatz weiterhin funktionssicher zu gestalten, wobei besonders gute Voraussetzungen zur Ableitung der durch die elektronischen Bauelemente erzeugten Wärme realisiert werden sollen. Die ABS/ESP-Druckregelvorrichtung nach der Erfindung soll einen neuartigen mechatronischen Aufbau haben, welcher ermöglicht, hochwertige Druckregelvorrichtungen in einer Massenproduktion von mehreren Millionen Einheiten pro Jahr erheblich kostengünstiger herzustellen, als ABS/ESP-Druckregelvorrichtungen nach dem Stand der Technik.

Diese Aufgabe wird gelöst durch die elektrohydraulische Druckregelvorrichtung gemäß Anspruch 1.

Die erfindungsgemäße elektrohydraulische Druckregelvorrichtung ist aus einer elektronischen Kontrolleinheit (Reglergehäuse), welche primär zur Aufnahme von elektronischen Regelbaugruppen und der Magnetspulen dient, und einem Hydraulikaggregat (z.B. metallischer Ventilblock) zusammengesetzt.

Die Druckregelvorrichtung gemäß der Erfindung wird bevorzugt in elektronischen Kraftfahrzeugbremssystemen, insbesondere mit ABS- und/oder ESP-Funktionalität, eingesetzt. Die elektronische Kontrolleinheit führt dann die für diese Anwendungen notwendigen Steuer- und Regelaufgaben aus. Es handeltsich um einen größtenteils vollkommen neu konzipierten Aufbau, welcher weiterhin die vielfältigen, üblichen elektromechanischen Anforderungen, die an Steuergeräte für Kraftfahrzeugbremssystem üblicherweise gestellt werden, wie mechanische Robustheit, Betriebssicherheit, Standzeit, elektrische Betriebssicherheit, thermische Betriebssicherheit, optimale Ausnutzung des Bauraums, Dichtigkeit gegen Hydrauliköl, EMV-Schutz, geringer Herstellungsaufwand etc. ausreichend erfüllt. Der Fertigungsaufwand gegenüber bekannten Systemen wird jedoch drastisch reduziert.

Die elektronische Kontrolleinheit umfasst mindestens eine erste Leiterplatte zur Aufnahme von elektrischen und/oder elektronischen Bauteilen, auf der beispielsweise der Chipsatz für das ABS/-ESP-System angeordnet ist. Bevorzugt ist auf der ersten Leiterplatte eine weitere, kleinere Zusatzleiterplatte aufgesetzt, welche insbesondere nur durch Kontaktpins gehalten wird. Diese Zusatzleiterplatte kann z.B. eine Ergänzungsfunktionalität, wie z.B. eine Elektronik für ein TPMS-Reifendrucküberwachungssystem enthalten.

Zur elektrischen Ansteuerung der Elektromotoreinheit hat sich unter anderem aus Bauraumgründen eine Durchführung mittels eines Adapters durch insbesonders jeweils eine Bohrung des Hydraulikaggregats bewährt. Nach der Erfindung wird der Adapter nicht fest mit der Kontrolleinheit verbunden, sondern es sind lösbare elektrische Kontaktpunkte vorgesehen, die neben einer einfachen Herstellung auch eine getrennte Fertigung und eine getrennte Verpackung von Kontrolleinheit und Adapter erlauben. Zum Herstellen eines betriebssicheren Kontakts ist mindestens ein Federelelement vorgesehen, welches den Kontaktpunkt des Adapters an eine geeignete Kontaktfläche drückt. Je nach Auslegung des Adapters sind Kontaktpunkte an beiden Enden des Adapters vorgesehen.

Bevorzugt ist die Kontrolleinheit mit dem Hydraulikaggregat über eine Steuergehäuseverbindung abdichtend, insbesondere unlösbar, verbunden. Das Reglergehäuse besteht beispielsweise aus einer einstückigen, relativ dünnwandigen Aluminiumhülle. Die Verbindung wird bei dieser Ausführungsform durch eine umlaufende Dichtung realisiert, welche in einer Nut geführt ist. Die Dichtung, welche beispielsweise ein O-Ring sein kann, verläuft auf der seitlichen Umfangsfläche des Hydraulikaggregats in einer Nut. Dabei ist es besonders zweckmäßig, wenn ein überstehender Gehäusewandungsbereich die in der Dichtung geführt Nut im wesentlichen überdeckt.

Das vorstehend beschriebene Dichtkonzept ermöglicht auch die Herstellung der Vorrichtung nach einem neuartigen Verfahren. Die Erfindung ermöglicht auch ein Verfahren zur Herstellung einer elektrohydraulischen Druckregelvorrichtung für Kraftfahrzeugbremssysteme mit den Schritten:
- Bereitstellung einer elektronischen Kontrolleinheit,
- Bereitstellung eines Hydraulikaggregats,
- Zusammenfügen von Kontrolleinheit und Hydraulikaggregat und
- Durchführung eines Funktionstests,
wobei
- nach Durchführung des Funktionstests bei ordnungsgemäßer Funktion die weiter oben erwähnte Steuergehäuseverbindung unlösbar fixiert wird, insbesondere durch Verstemmen oder Umbördeln.

Die Funktionsprüfung umfasst neben den üblichen Tests vorzugsweise auch einen pneumatischen Dichtigkeitstest, welcher zum Beispiel zur Überprüfung der vorhandenen umlaufenden Dichtung vorgesehen ist.

Zwischen Kontrolleinheit und Hydraulikaggregat kann bevorzugt noch eine flächige Dichtlage eingesetzt werden, welche aus einem Hydraulikflüssigkeit und Wasser aufsaugenden Material, wie beispielsweise Papier oder Pappe, besteht. Hierdurch werden geringe Mengen von evtl. aus dem Ventilblock austretender Hydraulikflüssigkeit abgefangen.

Vorzugsweise werden auch erst beim Zusammenfügen von Kontrolleinheit und Hydraulikaggregat die elektrischen Kontakte der Ventilspulen mit dem Bauelementträger geschlossen oder hergestellt. Dies ist ein wichtiger Unterschied im Vergleich zu üblichen an sich bekannten Steuergeräten, da dort die Ventilspulen häufig mit der Kontrolleinheit fest verbunden sind. Die in der Kontrolleinheit vorhandenen Ventilspulen werden deshalb zweckmäßigerweise vor dem Zusammenfügen auf das Hydraulikaggregat aufgesetzt, so dass diese beim Zusammenfügen der Baugruppen fest fixiert sind. In diesem Zusammenhang ist es besonders zweckmäßig, wenn die Ventilspulen vor dem Zusammenfügen auf dem Hydraulikaggregat verdrehsicher verstemmt werden, so dass die Spulenkontakte eine fest vorgegebene Lage für die elektrische Verbindung mit der Leiterplatte einnehmen.

Die vorliegende Erfindung setzt sich außerdem mit dem Ziel auseinander, die Wärmeableitung der elektronischen Bauelemente zu verbessern. Dies wird bevorzugt durch die Ausführung des Gehäuses des Reglers aus Metall und das Vorsehen von geeigneten Wärmeleitbrücken zum Metallgehäuse und/oder dem Hydraulikaggregat bewerkstelligt.

Vorzugsweise ist im Bereich der Leiterplatte eine flächig angebundene Kühlplatte vorgesehen. Alternativ ist bevorzugt, die Leiterplatte lokal durch ins Gehäuse eingebetteten Metallkörper, insbesondere Metallhülsen zu kühlen. Weiterhin ist es möglich, die Leiterplatte durch eine Anbindung an den Ventilblock, welcher eine hohe Wärmekapazität hat, zu kühlen. Aber auch wärmeabführende bzw. wärmespeichernde Metallplatten, Kühlkörper und Kühlhütchen sind in diesem Zusammenhang vorteilhaft.

Weitere bevorzugte Ausführungsformen ergeben sich aus den Unteransprüchen.

Es zeigen
- Fig. 1: ein Steuergerät mit Motorstecker,
- Fig. 2: ein Steuergerät entsprechend Fig. 1 mit Zusatzdeckel,
- Fig. 3: mehrere Ausführungsbeispiele für eine Steuergehäuseverbindung,
- Fig. 4: ein weiteres Beispiel für einen Motorstecker,
- Fig. 5: einen Gehäusedeckel mit einem Anschlussstecker im Deckelbereich,
- Fig. 6: einen Gehäusedeckel mit Anschlussstecker im Deckelbereich und integriertem Schlagschutz,
- Fig. 7: Ausführungsdetails des Steckers in Fig. 5 und
- Fig. 8: ein Konzept zur Abdichtung des Steckers gemäß Fig. 7.

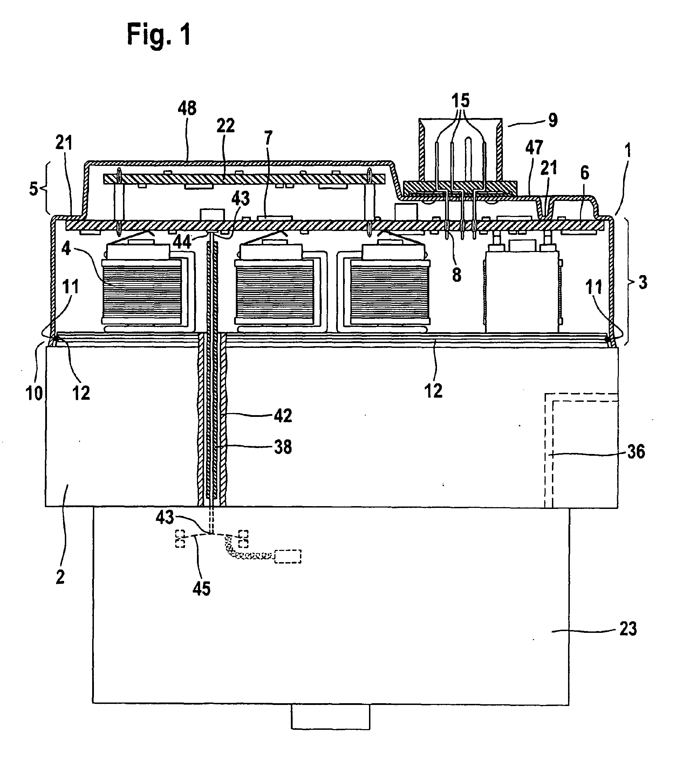

In Fig. 1 ist ein zusammengesetztes ABS/ESP-Steuergerät dargestellt. Regler 1, Ventilblock 2 und Elektromotoreinheit 23 stellen eine kompakte bauliche Einheit dar, wie sie zum Einbau in ein Kraftfahrzeug in der Regel zum geregelten Betrieb der Bremsanlage vorgesehen ist. Hierzu wird Ventilblock 2 an nicht dargestellte Hydraulikleitungen angeschlossen. Die Reglerelektronik 7 auf Platine 6 ist mit dem Kabelbaum über einen Anschlussstecker 9 verbindbar. Platine 6 wird von Ausbuchtungen 21 des Deckels in Richtung des Ventilblocks 2 gegen die elektrischen Kontakte der Ventilspulen 4 gedrückt.

Das einstückige Gehäuse des Reglers ist im wesentlichen entsprechend einer dünnwandigen, unten offenen Metallbox geformt. Entsprechend besteht die Box aus einem Gehäusevolumenbereich 3 und einem Gehäusedeckelbereich 5.

Der elektrische Anschluss von Elektromotoreinheit 23 erfolgt über einen isolierten, metallführende Kunststoffadapter (Motorstecker) 38, welcher durch eine Blockbohrung 42 zum Motor der Pumpe geführt ist. Im Falle von nur einer Blockbohrung ist ein zwei oder mehrpoliger Adapter vorgesehen. Wenn mehrere Adapter eingesetzt werden, können diese auch einpolig ausgeführt sein. Der bzw. die Leiter innerhalb eines Adapters ist/sind aus einem starren Metalldraht gefertigt und besteht/bestehen aus einer geeigneten Cu-Legierung. Am oberen Ende des Metalldrahtes bildet dieser einen Kontaktpunkt 43, welcher an einem auf Platine 6 aufgelöteten flächigen SMD-Kontakt (z.B. Cu-Plättchen) 44 aufliegt.

Im Bereich des zum Motor führenden Adapterendes ist eine Kontaktfeder 45 (z.B. Blattfeder oder Spiralfeder) vorgesehen, die vorzugsweise ebenfalls aus einer Cu-Legierung gefertigt ist. Federelement 45 ist direkt im Motorbereich integriert. Die Verbindung zum Motor bzw. zu einer Motorelektronik erfolgt besonders einfach über einen an das Federelement angecrimpten Draht oder eine Litze. Eine besonders einfache Möglichkeit der Kontaktierung besteht darin, den Kontaktpin des Adapters auf der Motorseite zum Einklemmen des Draht oder der Litze zwischen Feder und Kontaktpin einzusetzen. Besonders einfach ist es, wenn als Verbindungsdraht der mit den Bürsten des Motor verschweißte Draht verwendet wird. Die dargestellte Kontaktanordnung bestehend aus einem auf Leiterplatte 6 angeordneten flächigen SMD-Plättchen 44, einem Metallstab und diesen andrückenden Federelement 45 ergibt eine hinreichend sichere elektrische Verbindung, welche die erforderlichen Motorströme problemlos übertragen kann. Entsprechend können bevorzugt die SMD-Kontakte auch zur Kontaktierung der Spulen eingesetzt werden, wobei in diesem Fall die Spulenkontakte insbesondere als Blattfederelemente ausgeführt sind. Es ist ebenfalls bevorzugt, etwaige Drucksensorelemente ebenfalls einem entsprechenden Federkonzept folgend zu kontaktieren, wobei hier eine Lösung mit Spiralfederkontakten besonders bevorzugt wird.

Der zylinderförmige Adapter ist im einfachsten Fall als einpoliger Leiter ausgeführt, so dass bei einem Bürstenmotor zumindest zwei Adapter und zwei Blockbohrungen erforderlich sind. Selbstverständlich lässt sich das Konzept der Kontaktpins auch auf Adapter mit mehreren Polen übertragen. Im Falle von mehrpoligen Adaptern können für den Anwendungsfall eines bürstenlosen Motors drei Leiter besonders sinnvoll sein.

Der Block kann als weitere Ausführungsmöglichkeit eine Drainage 36 zum Abführen von Hydraulikflüssigkeit aus dem Bereich der Elektromotoreinheit umfassen.

Beispielhaft ist in Fig. 1 eine weitere Zusatzplatine 22 dargestellt. Zusatzplatine 22 ist für zusätzliche hardwareintensive Funktionen, wie z.B. TPMS-Hardware vorgesehen. Zusatzplatine 22 ist ähnlich einem Podest lediglich über Einpresskontakte 20 an die Hauptleiterplatte 6 angebunden, welche zusätzlich auch die elektrischen Signale von und zu der Zusatzplatine übertragen. Um zusätzlichen Bauraum für Zusatzplatine 22 zur Verfügung zu stellen, weist Deckeloberseite 47 eine entsprechende Ausbuchtung 48 auf.

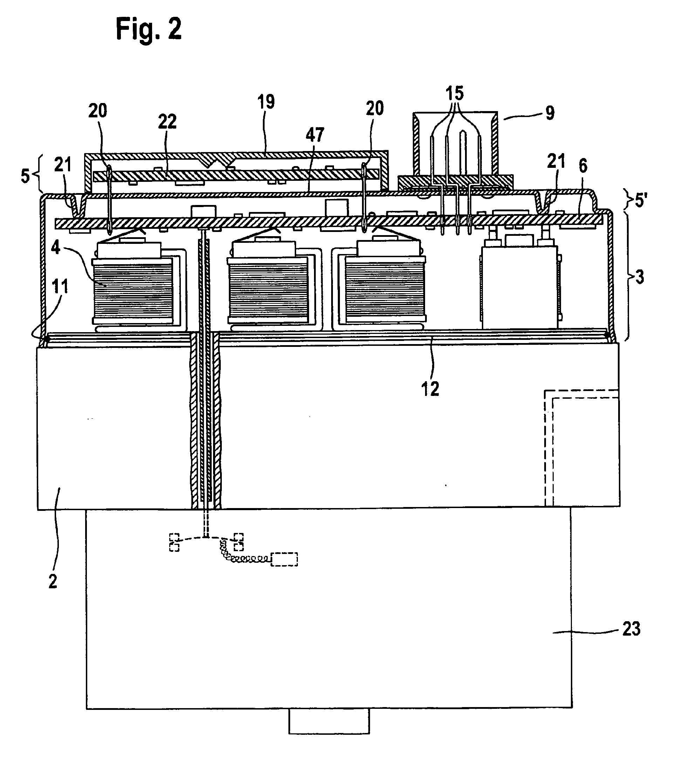

Das in Fig. 2 dargestellte Steuergerät entspricht weitestgehend dem Steuergerät in Fig. 1 mit dem Unterschied, dass die Deckeloberseite 46 im wesentlichen flach, also ohne eine Ausbuchtung für eine Zusatzplatine 22 gestaltet wurde. Im vorliegenden Beispiel ist Zusatzplatine 22 außen aufgesetzt und von einem aufgesetzten Zusatzgehäuse 19 eingeschlossen. Einpresskontakte 20 werden durch geeignete Öffnungen in Deckeloberseite 47 ins Gehäuseinnere geführt.

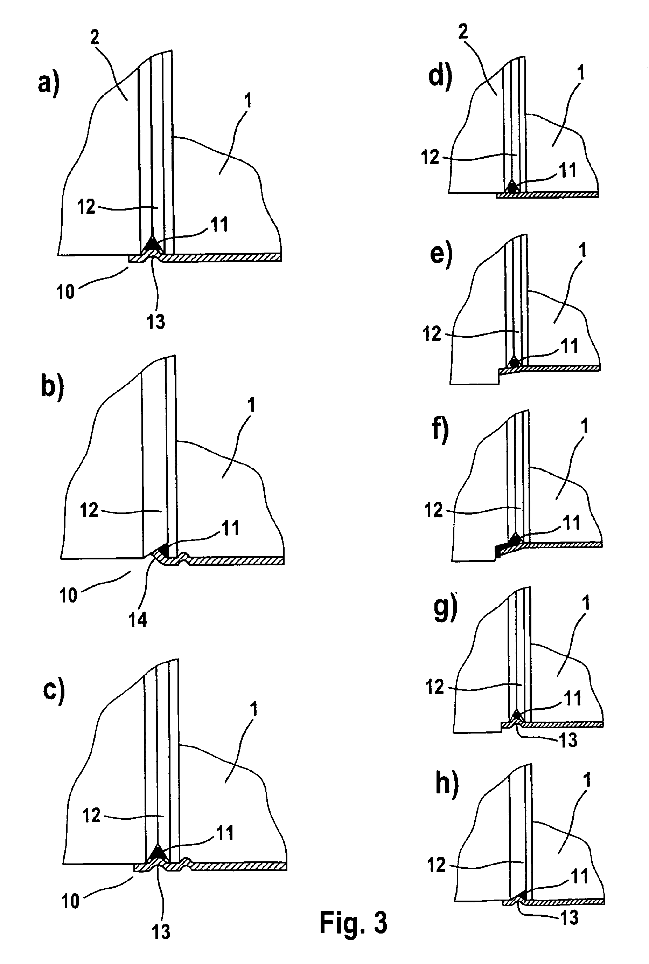

In Teilbildern a) bis h) von Fig. 3 sind verschiedene Möglichkeiten für Steuergehäuseverbindungen dargestellt. Gemeinsames Merkmal ist eine am Rand des Ventilblocks 2 umlaufende Nut 12, in der eine Dichtung 11 geführt wird. Die Kanten des Ventilblocks sind zumindest im Bereich des Deckelaufsatzes etwas abgerundet. Auf diese Weise ist gewährleistet, dass sich die ringförmige Dichtung 11 leicht in Nut 11 einlegen lässt.

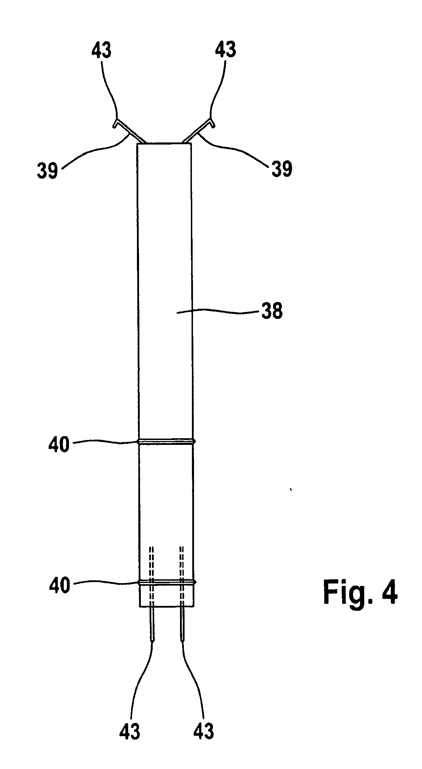

Fig. 4 zeigt einen alternativen Motorstecker 38, welcher vom Pumpenmotor durch Ventilblock 2 geführt ist und eine Verbindung mit der Hauptleiterplatte 6 herstellt. Motorstecker 38 weist zur Kontaktierung mit der Leiterplatte zwei gestanzte Federblechstreifen 39 auf, welche zweckmäßigerweise zur vereinfachten Kontaktierung bereits vorverzinnt sein können. Der Grundkörper des Motorsteckers umfasst im unteren Teil, welcher dem Motor zugewandt ist, zwei beabstandete Ringwülste 40, welche zum Abdichten und/oder Befestigen vorgesehen sind. Mit Ringwülsten 40 lässt sich erreichen, dass ein zum leichten Einführen etwas dünner als die Bohrung gefertigter Stab in der Bohrung ausreichend stabilisiert gehalten wird.

Alternativ kann dies auch mit einer auf der Staboberfläche angeordneten Noppenstruktur erreicht werden.

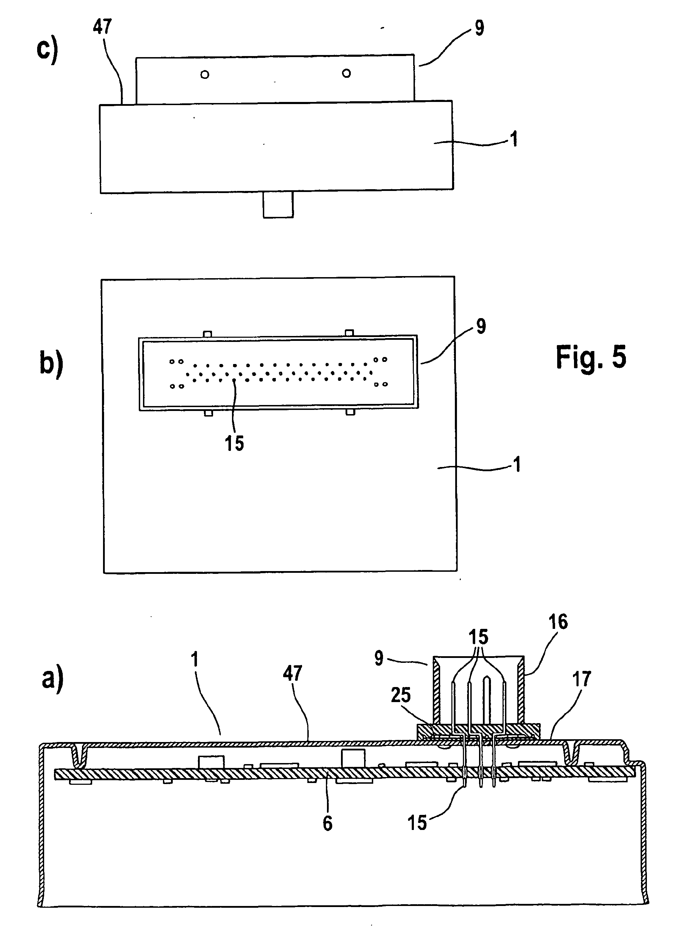

In Fig. 5 ist in verschiedenen Ansichten die Anbringung eines Anschlusssteckers 9 auf der Deckeloberseite 47 dargestellt, welcher lediglich einen Teil des Metalldeckels abdeckt. Stecker 9 weist mehrere Pins 15 aus leitfähigem Material auf, welche direkt als Einpresskontakte in geeignete Bohrungen der Leiterplatte geführt sind. Zwischen Stecker 9 und Metallgehäuse der Kontrolleinheit 1 befindet sich eine Dicht- und Isolierlage 25.

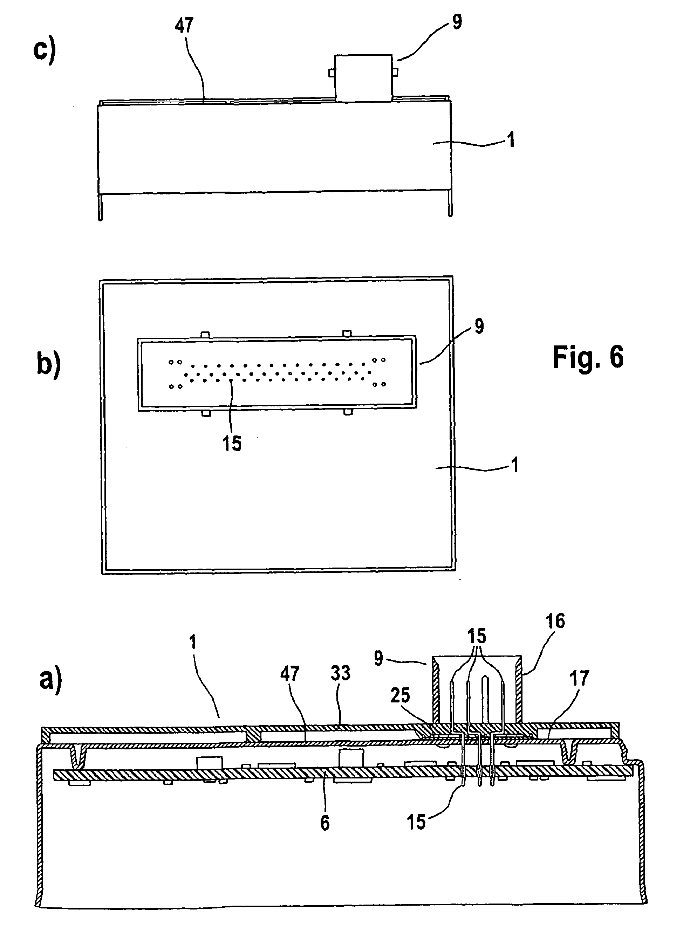

In Fig. 6 ist Anschlusssteckerbereich 17 mit einem aus Kunststoff bestehenden Teil 33 erweitert, welcher mit dem Kunststoff des Steckers einstückig verbunden ist. Teil 33 dient als Schlagschutz für die Deckeloberseite 47 und deckt einen größeren Teil des Metalldeckels, insbesondere im wesentlichen den gesamten Deckelbereich ab.

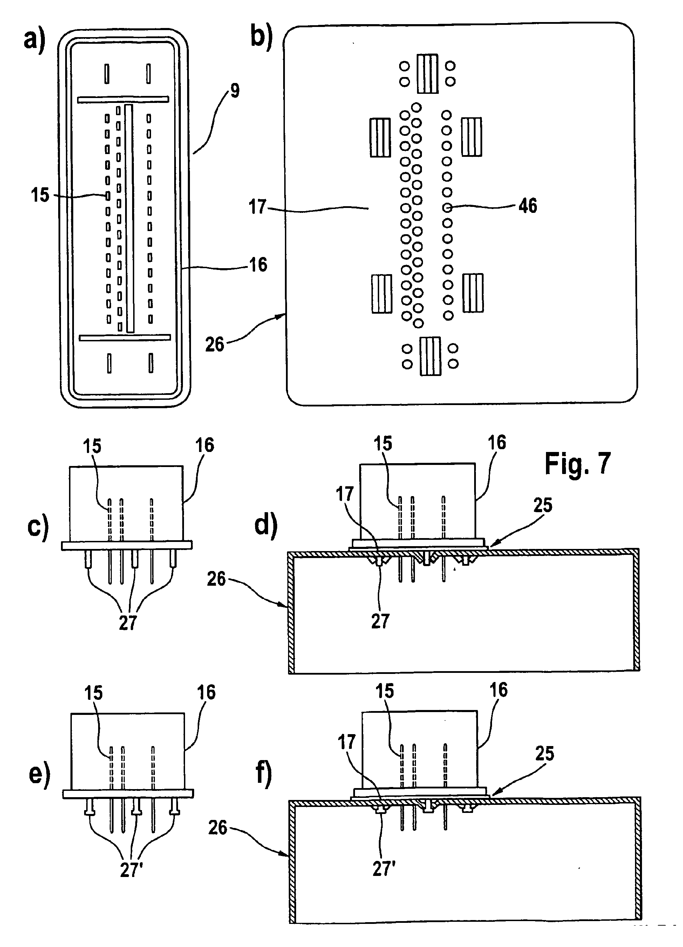

Teilbild a) von Fig. 7 zeigt Stecker 9 in Aufsicht mit einer Vielzahl von Kontaktpins 15. Teilbild b) von Fig. 7 stellt ebenfalls in Aufsicht einen Deckelbereich 17 dar, in den rasterförmige Ausnehmungen 46 eingearbeitet sind. Eine Seitenansicht von Stecker 9 zeigt Teilbild c). In Teilbild d) ist dargestellt, wie Stecker 16 und Metallgehäuse 26 mittels Kunststoffnasen 27 zusammengesetzt und an Metallgehäuse 26 befestigt sind. Zwischen Stecker und Gehäuse 26 ist abermals eine Dichtlage 25 angeordnet.

Da der Metalldeckel bzw. das Gehäuse aus Metall besteht, kann bei Bedarf der Bereich zwischen den Ausnehmungen und Kontaktpins 15 zusätzlich mit einem nichtleitenden Abdichtmittel ausgefüllt sein. Das Volumen des mit Abdichtmittel ausgefüllten Bereichs kann so gering gewählt sein, dass durch die Anordnung aus Steckerpin, Metallgehäuse und Abdichtmittel (z.B. als Elektrolyt wirkend), ein Kondensator und/oder eine definierte Funkenüberschlagsfläche gebildet wird, welcher insbesondere die elektronischen Bauelemente der Kontrolleinheit vor EMV-Strahlung schützt.

In Teilbildern e) und f) sind die Befestigungsnasen 27' aus Kunststoff mit einem Rastkopf versehen. Dieser kann insbesondere pilzförmig oder nagelförmig ausgebildet sein. Hierdurch lässt sich mit der flächigen Dichtlage 25 ein geeigneter Anpressdruck des Steckerteils realisieren.

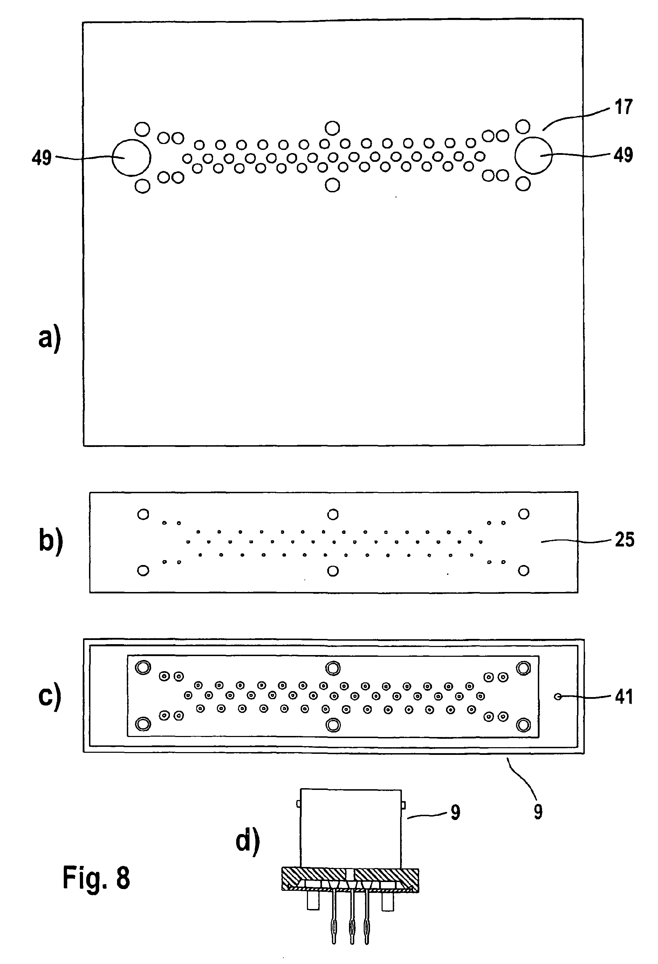

In Fig. 8 a) ist eine weitere Ausführungsform eines Gehäusedeckelbereichs 17 in Aufsicht dargestellt. Die zwischen Stecker 9 und Gehäusedeckelbereich 17 angeordnete Dichtlage zeigt Teilbild b) ebenfalls in Aufsicht. Teilbild c) stellt eine Ansicht des Steckers 9 von unten dar. Teilbild d) zeigt Stecker 9 von der Seite.

Stecker 9 weist auf der Unterseite im Steckerrand eine kleine Druckprüföffnung 41 auf. Durch diese kann Druck in das Steuergerät eingelassen werden, um während der Produktion zur Qualitätssicherung einen Dichtigkeitstest vorzunehmen.

Ein Druckausgleich kann flächig über den Bereich der Gummiabdichtung 25 erfolgen, da unterhalb Gummiabdichtung im Gehäusedeckel ein oder mehrere größere Ausnehmungen 49 vorgesehen sind, welche durch die Gummifläche 25 abgedeckt sind.

In den vorstehenden Beispielen ist die Einheit aus Gehäusevolumenbereich 3 und Deckelbereich 5, von Zusatzgehäuse 19 abgesehen, als einstückiges Metallgehäuse beschrieben. Anschließend wird noch ohne Bezugnahme auf eine Figur ein alternatives Beispiel zur Befestigung eines getrennten Gehäusedeckels auf einem Gehäuserahmen beschrieben. In an sich bekannten Steuergeräten dieser Art ist der Gehäusedeckel, welcher z.B. aus Kunststoff besteht, mittels Schrauben befestigt, wobei die Schrauben durch im Gehäuserahmen eingegossene Metallhülsen geführt sind. Die Schrauben greifen dabei in entsprechende Gewindebohrungen in Ventilblock 2 ein und drücken den Gehäusedeckel an. Dieser dichtet dann über eine geeignete, auf dem Gehäuserand liegende umlaufende Dichtung gegenüber dem Gehäuserahmen ab. Wenn nun an Stelle eines Kunststoffdeckels ein relativ steifer Metalldeckel verwendet wird, kann auf die im Kunststoffrahmen eingelassenen Metallhülsen vorteilhafterweise verzichtet werden, da der Metalldeckel auf Grund seiner Steifigkeit durch den Anpressdruck der Schrauben nicht verzogen wird.

Eine besonders einfache Realisierung des zuvor beschriebenen Metalldeckelkonzepts besteht darin, dass an einer Seite des Metalldeckels der Deckelrand etwas umgekantet ist und der umgekantete Teil klemmend oder rastend mit einer Gehäusewand wand verbunden wird. Wenn die Klemmung oder Rastung in geeigneter Weise ausgeführt wird, können nun auf den gegenüberliegenden Deckelseiten Schrauben zur weiteren Befestigung eingedreht werden, welche den Deckel gleichmäßig an den Gehäuserahmen anziehen. Diese Lösung ist besonders vorteilhaft, wenn der Gehäuserahmen einen seitlichen, über den Ventilblock hinausragenden Steckerbereich umfasst, in den keine Befestigungsschrauben eingedreht werden können.

## Patentansprüche

1. Elektrohydraulische Druckregelvorrichtung für Kraftfahrzeugbremssysteme, umfassend eine elektronische Kontrolleinheit (1), welche mit einem Hydraulikaggregat (2) verbunden ist, wobei die Kontrolleinheit
- einen Gehäusevolumenbereich (3) zur Aufnahme mehrerer in diesem Bereich angeordneter Ventilspulen (4),
- einen Gehäusedeckelbereich (5, 5') des Gehäuses der Kontrolleinheit,
- mindestens eine erste Leiterplatte (6) zur Aufnahme von elektrischen und/oder elektronischen Bauteilen (7) und einer elektrischen Kontaktierung (8) für einen Anschlussstecker (9) umfasst und
- mindestens einen Adapter (38) für eine mit der Hydraulikeinheit verbundenen Elektromotoreinheit (23), welcher durch das Hydraulikaggregat hindurchgeführt ist, und
- einen oder mehrere elektrische Druckkontaktpunkte (43) an einem oder an beiden Enden des Adapters (38), wobei der oder die Druckkontaktpunkte mittels Federkraft auf eine oder mehrere Kontaktflächen (44, 45) gedrückt werden, **dadurch gekennzeichnet, dass** die auf der Leiterplatte angeordneten Kontaktflächen, auf die sich die Druckkontaktpunkte des Adapters abstützen, SMD-fähige Bauelemente (44) sind, wobei diese auf der Unterseite der Leiterplatte bestückt sind.

2. Vorrichtung nach Anspruch 1, **dadurch gekennzeichnet, dass** die Druckkontaktpunkte an der der Pumpenantriebseinheit zugewandten Seite des Adapters auf einem Federelement (45) direkt oder indirekt aufliegen, wodurch die elektrisch leitende Verbindung zu einer Motorbürste oder einer Motorwicklung hergestellt wird.

3. Vorrichtung nach mindestens einem der vorhergehenden Ansprüche, **dadurch gekennzeichnet, dass** der oder die Druckkontaktpunkte durch Enden eines bzw. mehrerer Metallstäbe gebildet werden, die zumindest in einem Teilbereich von Kunststoff ummantelt sind, welcher insbesondere die Außenhülle des Adapters bildet.

4. Vorrichtung nach mindestens einem der vorhergehenden Ansprüche, **dadurch gekennzeichnet, dass** die Druckkontaktpunkte (43) durch Federkontakte (39) gebildet sind und insbesondere an der der Pumpenantriebseinheit zugeordneten Seite eine lösbare verdrehgeschützte elektrische Verbindung zum Pumpenmotor bzw. zu einer Motorbürste vorgesehen ist.

5. Vorrichtung nach mindestens einem der vorhergehenden Ansprüche, **dadurch gekennzeichnet, dass** der Adapter zylinderförmig ausgebildet ist und auf der Zylinderoberfläche zwei oder mehrere Ringwülste (40) aufweist.

6. Vorrichtung nach mindestens einem der vorhergehenden Ansprüche, **dadurch gekennzeichnet, dass** die Kontrolleinheit mit dem Hydraulikaggregat über eine Steuergehäuseverbindung (10) abdichtend, insbesondere unlösbar, verbunden ist, und dass das Hydraulikaggregat eine zu der dem Hydraulikaggregat zugewandten Seite auf einer Umfangsfläche eine umlaufende Nut (12) aufweist, in der eine umlaufende Dichtung (11) geführt ist, welcher derart ausgeführt ist, dass Gehäusevolumenbereich (3) die in der Dichtung geführt Nut im wesentlichen vollständig überdeckt.

7. Vorrichtung nach mindestens einem der vorhergehenden Ansprüche, **dadurch gekennzeichnet, dass** im Bereich der Steuergehäuseverbindung der Gehäusevolumenbereich (3) eine ringförmige, in das Gehäuseinnere gerichtete Erhebung (13) aufweist, welche beim Zusammenfügen von Kontrolleinheit und Hydraulikaggregat in die Nut (12) der Steuergehäuseverbindung einrastet.

8. Vorrichtung nach mindestens einem der vorhergehenden Ansprüche, **dadurch gekennzeichnet, dass** die Steuergehäuseverbindung in dem zur Abdichtung vorgesehenen Gehäusewandungsbereich eine in das Gehäuseinnere gerichtete ringförmige Umbördelung (14), Einpressung Einstemmung oder Einrollung aufweist, welche nach dem Zusammenfügen von Kontrolleinheit und Hydraulikaggregat oder nach dem Umbördeln des Gehäuserandes eine abdichtende Klemmung im Zusammenwirken mit der Nut hervorruft.

9. Vorrichtung nach mindestens einem der vorhergehenden Ansprüche, **dadurch gekennzeichnet, dass** zwischen Kontrolleinheit und Hydraulikaggregat eine flächige Dichtlage eingesetzt ist, welche aus einem Hydraulikflüssigkeit und Wasser aufsaugenden Material, wie beispielsweise Papier oder Pappe, besteht.

10. Vorrichtung nach mindestens einem der vorhergehenden Ansprüche, **dadurch gekennzeichnet, dass** im Gehäusedeckelbereich (5, 5') auf der Deckeloberseite (47) ein Anschlussstecker (9) angeordnet ist, wobei das Gehäuse im Bereich (17) um den Anschlussstecker aus Metall besteht und der Anschlussstecker einen aufgesetzten Steckerkragen (16) umfasst, welcher aus Kunststoff besteht.

11. Vorrichtung nach mindestens einem der vorhergehenden Ansprüche, **dadurch gekennzeichnet, dass** der Gehäusevolumenbereich (3) und insbesondere auch der Gehäusedeckelbereich (5, 5') im wesentlichen aus Metall bestehen und gemeinsam ein Reglergehäuse bilden.

12. Vorrichtung nach mindestens einem der vorhergehenden Ansprüche, **dadurch gekennzeichnet, dass** der Anschlussstecker aus Kunststoff besteht und den Gehäusedeckel mit einem aus Kunststoff bestehenden Abdeckteil (33) großflächig abdeckt.

13. Vorrichtung nach mindestens einem der vorhergehenden Ansprüche, **dadurch gekennzeichnet, dass** Anschlussstecker (9) eine Vielzahl von Kontaktpins (15) aufweist, welche durch eine im wesentlichen entsprechende Anzahl von Deckel- oder Gehäuseausnehmungen (46) geführt sind, wobei der Bereich zwischen den Ausnehmungen und den Kontaktpins (15) mit einer Dichtlage (25) und/oder einem Abdichtmittel ausgefüllt ist.

## Claims

1. Electrohydraulic pressure control apparatus for motor-vehicle brake systems, comprising an electronic control unit (1) which is connected to a hydraulic assembly (2), wherein the control unit comprises
- a housing volume region (3) for receiving a plurality of valve coils (4) which are arranged in this region,
- a housing cover region (5, 5') of the housing of the control unit,
- at least one first printed circuit board (6) for receiving electrical and/or electronic components (7) and an electrical contact-making means (8) for a connection plug (9), and
- at least one adapter (38) for an electric-motor unit (23) which is connected to the hydraulic unit and which is routed through the hydraulic assembly, and
- one or more electrical pressure contact points (43) at one or at both ends of the adapter (38), wherein the pressure contact point or points are pressed onto one or more contact areas (44, 45) by means of spring force, **characterized in that** the contact areas which are arranged on the printed circuit board and on which the pressure contact points of the adapter are supported are SMD-compatible components (44), wherein these are mounted on the lower face of the printed circuit board.

2. Apparatus according to Claim 1, **characterized in that** the pressure contact points lie directly or indirectly on a spring element (45) on that side of the adapter which faces the pump drive unit, as a result of which the electrically conductive connection to a motor brush or a motor winding is established.

3. Apparatus according to at least one of the preceding claims, **characterized in that** the pressure contact point or points is/are formed by ends of one or more metal rods which, at least in a subregion, are sheathed in plastic which forms, in particular, the outer casing of the adapter.

4. Apparatus according to at least one of the preceding claims, **characterized in that** the pressure contact points (43) are formed by spring contacts (39), and a releasable rotation-protected electrical connection to the pump motor or to a motor brush is provided, in particular, on that side which is associated with the pump drive unit.

5. Apparatus according to at least one of the preceding claims, **characterized in that** the adapter is cylindrical and has two or more annular beads (40) on the cylinder surface.

6. Apparatus according to at least one of the preceding claims, **characterized in that** the control unit is connected to the hydraulic assembly by means of a control housing connection (10) in a sealed-off, in particular permanent, manner, and **in that** the hydraulic assembly has a circumferential groove (12) on a circumferential face on the side facing the hydraulic assembly, a circumferential seal (11) being routed in the said circumferential groove and being designed in such a way that the housing volume region (3) substantially completely covers the groove which is guided in the seal.

7. Apparatus according to at least one of the preceding claims, **characterized in that**, in the region of the control housing connection, the housing volume region (3) has an annular raised portion (13) which is directed into the housing interior and which latches into the groove (12) in the control housing connection when the control unit and the hydraulic assembly are joined.

8. Apparatus according to at least one of the preceding claims, **characterized in that** the control housing connection has an annular beading (14), pressed-in portion, caulked-in portion or rolled-in portion, which is directed into the housing interior, in the housing wall region which is provided for sealing-off purposes, the said beading, pressed-in portion, caulked-in portion or rolled-in portion creating a sealed-off clamping connection in interaction with the groove after the control unit and the hydraulic assembly are joined or after the housing edge is beaded.

9. Apparatus according to at least one of the preceding claims, **characterized in that** a flat sealing layer is inserted between the control unit and the hydraulic assembly, the said sealing layer being composed of a material which absorbs hydraulic fluid and water, for example paper or board.

10. Apparatus according to at least one of the preceding claims, **characterized in that** a connection plug (9) is arranged on the cover upper face (47) in the housing cover region (5, 5'), wherein the housing is composed of metal in the region (17) around the connection plug, and the connection plug comprises a fitted plug collar (16) which is composed of plastic.

11. Apparatus according to at least one of the preceding claims, **characterized in that** the housing volume region (3) and, in particular, also the housing cover region (5, 5') are composed substantially of metal and together form a controller housing.

12. Apparatus according to at least one of the preceding claims, **characterized in that** the connection plug is composed of plastic and covers a large area of the housing cover by way of a cover part (33) which is composed of plastic.

13. Apparatus according to at least one of the preceding claims, **characterized in that** the connection plug (9) has a large number of contact pins (15) which are routed through a substantially corresponding number of cover or housing recesses (46), wherein the region between the recesses and the contact pins (15) is filled with a sealing layer (25) and/or a sealing-off means.

## Revendications

1. Dispositif de régulation de pression électrohydraulique pour systèmes de freinage de véhicule automobile, comprenant une unité de contrôle électronique (1) reliée à un groupe hydraulique (2), l'unité de contrôle comprenant :
- un volume de carter (3) permettant de loger plusieurs bobines de soupape (4) disposées dans cette zone ;
- une zone de cache de carter (5, 5') du carter de l'unité de contrôle ;
- au moins une première plaque conductrice (6) permettant de loger des composants électriques et/ou électroniques (7) et une mise en contact électrique (8) prévue pour une fiche de raccordement (9) ; et
- au moins un adaptateur (38) prévu pour une unité de moteur électrique (23) reliée à l'unité hydraulique et guidé au travers du groupe hydraulique ; et
- un ou plusieurs points de contact par pression (43) électriques prévus au niveau d'une ou des deux extrémités de l'adaptateur (38), le ou les points de contact par pression étant comprimés par la force de ressort sur une ou plusieurs surfaces de contact (44, 45) ;
**caractérisé en ce que** les surfaces de contact disposées sur la plaque conductrice sur lesquelles s'appuient les points de contact par pression de l'adaptateur sont des composants (44) compatibles SMD placés sur le côté inférieur de la plaque conductrice.

2. Dispositif selon la revendication 1, **caractérisé en ce que** les points de contact par pression reposent directement ou indirectement contre le côté de l'adaptateur orienté vers l'unité d'entraînement de pompe sur un élément de ressort (45), la liaison électriquement conductrice établie prenant la forme d'une brosse de moteur ou d'un enroulement de moteur.

3. Dispositif selon au moins l'une quelconque des revendications précédentes, **caractérisé en ce que** le ou les points de contact par pression sont formés par les extrémités d'une et/ou de plusieurs tiges métalliques enveloppées au moins dans une zone partielle de matière plastique et formant notamment l'enveloppe extérieure de l'adaptateur.

4. Dispositif selon au moins l'une quelconque des revendications précédentes, **caractérisé en ce que** les points de contact par pression (43) sont formés par des contacts par ressort (39) et qu'une liaison électrique amovible protégée contre les torsions assurant la liaison avec le moteur de pompe et/ou avec une brosse de moteur est prévue, notamment au niveau du côté associé à l'unité d'entraînement de pompe.

5. Dispositif selon au moins l'une quelconque des revendications précédentes, **caractérisé en ce que** l'adaptateur prend une forme de cylindre et comporte deux bourrelets annulaires (40) ou plus sur la surface du cylindre.

6. Dispositif selon au moins l'une quelconque des revendications précédentes, **caractérisé en ce que** l'unité de contrôle est reliée au groupe hydraulique de façon étanchéifiée, notamment inamovible, via une liaison de carter de commande (10) et que le groupe hydraulique comporte une rainure (12) périphérique placée sur une surface périphérique par rapport au côté orienté vers le groupe hydraulique dans laquelle un joint (11) périphérique est guidé de telle sorte que le volume de carter (3) recouvre pour l'essentiel entièrement la rainure guidée dans le joint.

7. Dispositif selon au moins l'une quelconque des revendications précédentes, **caractérisé en ce que** le volume de carter (3) comporte une éminence (13) annulaire orientée à l'intérieur du carter et s'encliquetant dans la rainure (12) de la liaison de carter de commande dans la zone de la liaison de carter de commande lors de l'assemblage de l'unité de contrôle et du groupe hydraulique.

8. Dispositif selon au moins l'une quelconque des revendications précédentes, **caractérisé en ce que** la liaison de carter de commande comporte un bordage (14), un sertissage, un mortaisage ou un enroulement annulaire orienté à l'intérieur du carter prévu pour réaliser l'étanchéité dans la zone de paroi de carter, ledit système provoquant un coincement étanche en interaction avec la rainure après l'assemblage de l'unité de contrôle et du groupe hydraulique ou après le bordage du bord de carter.

9. Dispositif selon au moins l'une quelconque des revendications précédentes, **caractérisé en ce qu'**une épaisseur plane est insérée entre l'unité de contrôle et le groupe hydraulique et que cette épaisseur est composée d'un fluide hydraulique et d'un matériau absorbant l'eau, par exemple du papier ou du carton.

10. Dispositif selon au moins l'une quelconque des revendications précédentes, **caractérisé en ce qu'**une fiche de raccordement (9) est disposée dans la zone de cache de carter (5, 5') sur le côté supérieur du cache (47), le carter se composant de métal dans la zone (17) entourant la fiche de raccordement et la fiche de raccordement comprenant un collet (16) d'enfichage en matière plastique monté dessus.

11. Dispositif selon au moins l'une quelconque des revendications précédentes, **caractérisé en ce que** le volume de carter (3) et notamment également la zone de cache de carter (5, 5') sont pour l'essentiel composés de métal et forment ensemble un carter de régulateur.

12. Dispositif selon au moins l'une quelconque des revendications précédentes, **caractérisé en ce que** la fiche de raccordement est réalisée en matière plastique et recouvre sur une grande partie de sa surface le cache de carter d'une partie de cache (33) en matière plastique.

13. Dispositif selon au moins l'une quelconque des revendications précédentes, **caractérisé en ce que** la fiche de raccordement (9) comporte une pluralité de broches de contact (15) guidées à travers un nombre pour l'essentiel correspondant d'évidements de cache ou de carter (46), la zone située entre les évidements et les broches de contact (15) étant remplie d'une couche étanche (25) et/ou d'un moyen d'étanchéification.
